# EUROPÄISCHE PATENTSCHRIFT

(11) **EP 0 572 066 B1**
(45) Veröffentlichungstag und Bekanntmachung des Hinweises auf die Patenterteilung: **21.08.1996**
(21) Anmeldenummer: 93201417.8
(22) Anmeldetag: 18.05.1993
(51) Int. Cl.: H02M 3/07, G11C 5/14, G06K 7/08, H02M 7/25, B61L 25/04

(54) **Schaltungsanordnung zum Erzeugen einer Versorgungsspannung**
Circuit to generate a supply voltage
Circuit pour générer une tension d'alimentation

(30) Priorität: 26.05.1992 DE 4217382
(43) Veröffentlichungstag der Anmeldung: 01.12.1993
(73) Patentinhaber: Philips Patentverwaltung GmbH, 22335 Hamburg (DE); Philips Electronics N.V., 5621 BA Eindhoven (NL)
(72) Erfinder: Axer, Klaus, Dr., c/o Philips Patentverwaltung, W-2000 Hamburg 1 (DE)
(74) Vertreter: Poddig, Dieter, Dipl.-Ing.

(56) Entgegenhaltungen:
- EP-A- 0 079 047
- EP-A- 0 111 753
- EP-A- 0 319 063
- DE-A- 3 912 497
- US-A- 4 636 930
- IEEE JOURNAL OF SOLID-STATE CIRCUITS, Bd. SC-11, no. 3, Juni 1976, New York US, Seiten 374-378; J.F. DICKSON : "On-Chip High-Voltage Generation in MNOS Integrated Circuits Using an Improved Voltage Multiplier Technique"

## Beschreibung

Die Erfindung betrifft eine Schaltungsanordnung zum Erzeugen einer Versorgungsspannung für eine Speicherschaltung, die gespeicherte Daten nach außerhalb abgibt, mit einer Spule zum Empfangen eines magnetischen Wechselfeldes und Erzeugen einer Wechselspannung, einer an die Spule angeschlossenen Gleichrichterschaltung zum Erzeugen der Versorgungsspannung aus der Wechselspannung und einer Belastungsanordnung zum Erzeugen einer von den abzugebenden Daten abhängigen erhöhten Belastung der Spule.

Eine derartige Anordnung ist bekannt aus der EP-A-0 111 753 . Durch die Änderung der Belastung der Spule wird das magnetische Wechselfeld beeinflußt, das von einer Lesestation ausgesendet wird, die mit der Speicherschaltung zusammen arbeitet, und die Änderung des magnetischen Wechselfeldes kann in der Lesestation detektiert werden, so daß auf diese Weise die Daten von der Speicherschaltung kontaktlos durch die Lesestation aufgenommen werden können. Für die Steuerung der Speicherschaltung sind zusätzliche Logik- und Steuerschaltungen notwendig, die mit der Speicherschaltung zusammengefaßt sind. Unter Speicherschaltung ist daher nachfolgend immer die Kombination mit diesen zusätzlich notwendigen Schaltungen zu verstehen.

Die Auswertung der Änderung des magnetischen Wechselfeldes infolge der datenabhängigen Belastungsänderung ist zum einen um so sicherer, je stärker die Kopplung der Spule mit der Sendeeinrichtung der Lesestation ist, und zum anderen, je stärker die Belastungsänderung durch die Daten ist. Da die Kopplung aus mechanischen und praktischen Gründen nicht beliebig eng gemacht werden kann, sollte daher eine möglichst große Belastungsänderung durch die Daten erfolgen. Da von der Spule die Versorgungsspannung für die Speicherschaltung abgeleitet wird, so daß die Spule bereits dadurch in einem gewissen Maße belastet ist, und andererseits bei zu großer Belastung der Spule die von der Gleichrichterschaltung erzeugte Versorgungsspannung zu niedrig wird, ist das Ausmaß der zulässigen Belastungsänderung bei der bekannten Anordnung begrenzt.

Aufgabe der Erfindung ist es daher, eine Schaltungsanordnung der eingangs genannten Art anzugeben, die eine größere Belastungsänderung der Spule unter Aufrechterhaltung einer ausreichend großen Versorgungsspannung ermöglicht.

Diese Aufgabe wird erfindungsgemäß dadurch gelöst, daß parallel zur Gleichrichterschaltung eine von den abzugebenden Daten gesteuerte Spannungserhöherschaltung an die Spule angeschlossen ist zum Erzeugen einer gegenüber der Amplitude der Wechselspannung höheren Gleichspannung an einen Spannungsausgang als Versorgungsspannung für die Speicherschaltung während der Dauer der erhöhten Belastung.

Auf diese Weise wird die Spannungsversorgung der Speicherschaltung während der Dauer der erhöhten Belastung von der Spannungserhöherschaltung übernommen, so daß im belasteten Zustand nur eine geringe Wechselspannung an der Spule vorhanden sein muß. Die Spannungserhöherschaltung belastet die Spule zwar zusätzlich, jedoch nur während der Dauer der ohnehin erhöhten Belastung, so daß sich diese zusätzliche Belastung eher günstig auswirkt.

Das Ausmaß der erhöhten Belastung kann fest eingestellt sein. Dabei besteht jedoch die Gefahr, daß bei einer zu losen Kopplung zwischen dem Sender der Leseeinrichtung und der Spule die Wechselspannung an der Spule während der erhöhten Belastung so gering wird, daß auch die Spannungserhöherschaltung keine ausreichende Versorgungsspannung für die Speicherschaltung mehr erzeugen kann. Eine Ausgestaltung der Erfindung ist daher dadurch gekennzeichnet, daß der Spannungsausgang der Spannungserhöherschaltung über eine gleichrichtende Anordnung mit einem Versorgungsspannungseingang der Speicherschaltung und direkt mit einer Spannungsvergleicherschaltung verbunden ist, die ein Steuersignal abgibt, wenn die höhere Gleichspannung einen vorgegebenen Wert erreicht, und daß die Belastungsanordnung nur von diesem Steuersignal gesteuert die Belastung der Spule erhöht. Die Belastungsanordnung wird dabei also weiterhin von den abzugebenden Daten gesteuert, jedoch nicht mehr direkt, sondern dadurch, daß die Spannungserhöherschaltung, die von den abzugebenden Daten gesteuert wird, eine für die Versorgung der Speicherschaltung ausreichende Versorgungsspannung erzeugt. Dabei ist dann zwar das Ausmaß der Änderung des magnetischen Wechselfeldes, die in der Leseeinrichtung zum Rückgewinnen der Daten detektiert werden muß, von der elektromagnetischen Kopplung zwischen der Spule und dem Sender der Leseeinrichtung abhängig, jedoch wegen der erfindungsgemäßen Verwendung der Spannungserhöherschaltung auch bei relativ loser Kopplung noch ausreichend.

Eine Spannungserhöherschaltung kann beispielsweise mit induktiven Elementen aufgebaut werden, durch die ein periodisch geschalteter Strom von der Versorgungsspannung der Gleichrichterschaltung fließt. Allerdings können induktive Elemente praktisch nicht innerhalb einer integrierten Schaltung gebildet werden, so daß eine Schaltung mit Kapazitäten zweckmäßiger ist. Da die Gleichrichterschaltung jedoch allgemein einen Spannungsabfall der gleichgerichteten Spannung gegenüber der Spitzenamplitude der Wechselspannung aufweist, steht für eine solche Spannungserhöherschaltung während der erhöhten Belastung nur eine sehr geringe Signalspannung zur Verfügung. Um eine höhere Signalspannung für einen günstigeren Betrieb zu erhalten, ist es nach einer weiteren Ausgestaltung der Erfindung zweckmäßig, daß die Spannungserhöherschaltung eine Schalteranordnung mit einem Steuereingang zum Empfangen der abzugebenden Daten, zwei Eingängen, die mit der Spule verbunden sind, und zwei Schaltausgängen, die abhängig von den am Steuereingang empfangenen Daten mit einem zugeordneten Eingang bzw. mit einem Pol der Versorgungsspannung gekoppelt sind, und eine Spannungsvervielfacherschaltung umfaßt, die mit den Schaltausgängen verbunden ist. Eine derartige Schaltungsanordnung ist bereits in der älteren, nicht vorveröffentlichten deutschen Patentanmeldung P 41 00 209.1 vorgeschlagen worden und hat den Vorteil, daß die an der Spule auftretende Wechselspannung vollständig als Signalspannung für die Spannungsvervielfacherschaltung zur Verfügung steht.

Für die Realisierung innerhalb einer integrierten Schaltung ist eine Spannungsvervielfacherschaltung mit Kapazitäten und Gleichrichtern am zweckmäßigsten. Bei einer mehrstufigen Vervielfachung sind dabei jedoch mehrere Gleichrichter in Reihe geschaltet, wobei sich deren Spannungsabfälle addieren, so daß eine solche Spannungsvervielfacherschaltung bei sehr geringer Eingangsspannung nur unwirtschaftlich arbeitet. Eine Weiterbildung der Erfindung mit wenigstens einer Spannungsvervielfacherschaltung, die mit Kapazitäten und gleichrichtenden Anordnungen aufgebaut ist, ist daher dadurch gekennzeichnet, daß jede gleichrichtende Anordnung durch die Hauptstrombahn eines ersten Feldeffekttransistors gebildet ist, dessen Gate mit einer Vorspannungsschaltung verbunden ist zum Liefern einer Vorspannung für das Gate gegenüber einem Anschluß der Hauptstrombahn, um die wirksame Schwellenspannung des Feldeffekttransistors im leitenden Zustand zu verringern, wobei die Vorspannungsschaltung Kapazitäten und gleichrichtende Anordnungen in Form von weiteren Feldeffekttransistoren enthält. Eine derartige Schaltungsanordnung ist bereits in der prioritätsälteren, nicht vorveröffentlichten europäischen Patentanmeldung ... (PHD 91-065 EP) vorgeschlagen und hat den Vorteil, daß die einzelnen gleichrichtenden Anordnungen nur einen äußerst geringen Spannungsabfall aufweisen und daß andererseits alle gleichrichtenden Elemente als Feldeffekttransistoren realisiert werden können, so daß sie in einer integrierten Schaltung mit demselben Prozeß wie die übrigen Elemente für die Datenverarbeitung und Datenspeicherung aufgebaut werden können.

Ausführungsbeispiele der Erfindung werden nachstehend anhand der Zeichnung näher erläutert. Darin zeigen
Fig. 1 eine bekannte Schaltungsanordnung zur kontaktlosen Energie- und Datenübertragung,
Fig. 2 ein Blockschaltbild einer erfindungsgemäßen Schaltungsanordnung,
Fig. 3 eine Abwandlung der Schaltungsanordnung nach Fig. 2,
Fig. 4 eine Gleichrichterschaltung sowie eine Schaltungsanordnung für die Spannungserhöherschaltung,
Fig. 5 das Grundprinzip einer Spannungsvervielfacherschaltung,
Fig. 6 einige Diagramme von Spannungsverläufen in der Spannungsvervielfacherschaltung,
Fig. 7 die Realisierung der Spannungsvervielfacherschaltung nach Fig. 5 mit ausschließlich Feldeffekttransistoren.

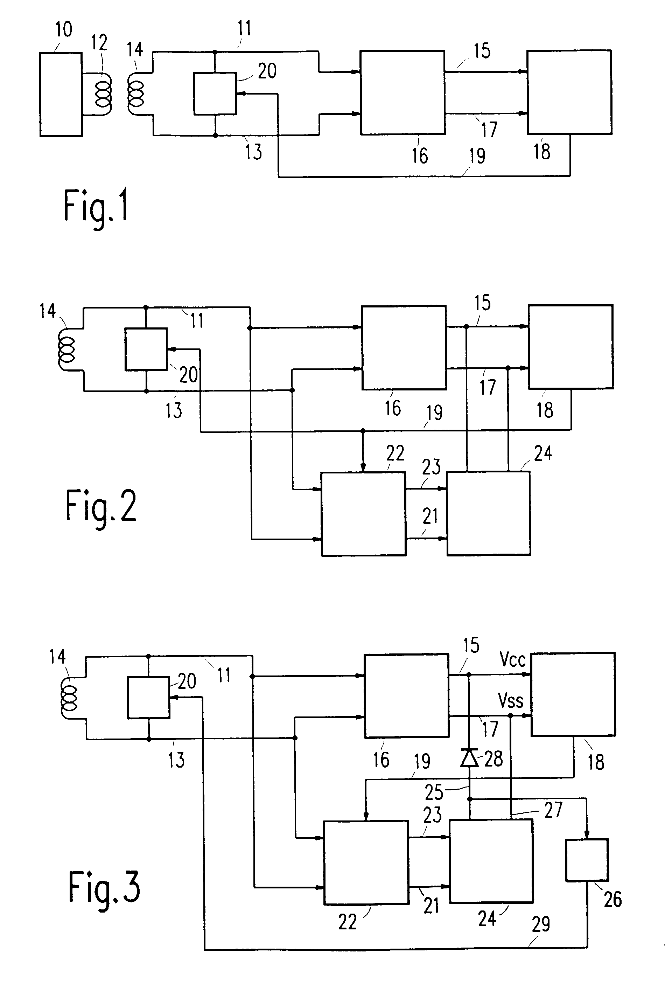

In Fig. 1 ist eine Lesestation 10 schematisch angedeutet, die einen Sender enthält, der eine Spule 12 speist. Das von dieser Spule erzeugte magnetische Wechselfeld wird von einer Spule 14 aufgenommen, die dadurch auf den Leitungen 11 und 13 eine Wechselspannung erzeugt, die einer Belastungsanordnung 20 und einer Gleichrichterschaltung 16 zugeführt wird. Die letztere erzeugt zwischen den Leitungen 15 und 17 eine Versorgungsspannung, die einer Speicherschaltung 18 zugeführt wird. Diese enthält Steuerschaltungen und einen Speicher, und die darin enthaltenen Daten werden beispielsweise seriell über die Leitung 19 ausgegeben und der Belastungsanordnung 20 zugeführt. Dabei werden die beiden Werte von binären Daten beispielsweise durch unterschiedliche Signaldauern oder Signalphasen angegeben, während denen die Belastungsanordnung 20 eine erhöhte Belastung zwischen den Leitungen 11 und 13 bildet. Die dadurch entstehende unterschiedliche Belastung der Spule 14 wirkt über das magnetische Wechselfeld auf die Spule 12 zurück und kann in der Lesestation 10 detektiert werden.

Wenn die elekromagnetische Kopplung zwischen den Spulen 12 und 14 nur gering ist, beispielsweise durch einen größeren räumlichen Abstand, wirkt sich eine veränderte Belastung der Spule 14 nur wenig in der Spule 12 aus, so daß die übertragenen Daten nur schwierig in der Lesestation 10 detektiert werden können. Zumindest ist es jedoch notwendig, daß die Belastungsanordnung 20 die Belastung der Spule 14, die durch den Gleichrichter 16 ohnehin vorhanden ist, wesentlich erhöht. Dadurch bricht dann jedoch auch die auf den Leitungen 11 und 13 von der Spule erzeugte Wechselspannung stark zusammen, so daß die Gleichrichterschaltung 16 nur eine geringe Versorgungsspannung an den Ausgängen 15 und 17 erzeugen kann, die für einen zuverlässigen Betrieb der Speicherschaltung nicht ausreichend sein kann.

Es sei bemerkt, daß die Speicherschaltung 18 zusammen mit der Gleichrichterschaltung 16 und der Belastungsanordnung 20 in einem einzigen Halbleiterkörper gemeinsam integriert sein können.

In Fig. 2 ist eine Schaltungsanordnung nach der Erfindung dargestellt, die eine erheblich größere Änderung der Belastung der Spule zuläßt. Dabei sind Elemente, die denen der Schaltungsanordnung nach Fig. 1 entsprechen, mit denselben Bezugszeichen bezeichnet.

An die Spule 14 ist über die Leitungen 11 und 13 nun zusätzlich auch eine Spannungserhöherschaltung angeschlossen, die aus einer Schalteranordnung 22 und einer Spannungsvervielfacherschaltung 24 besteht. Die Schalteranordnung 22 wird hier ebenfalls über die Leitung 19 von den Daten aus der Speicherschaltung 18 gesteuert. Abhängig von diesen Daten wird ein Schaltausgang 21 bzw. 23 mit der zugeordneten Eingangsleitung 11 bzw. 13 gekoppelt, so daß dann die von der Spule 14 erzeugte Spannung nahezu unverändert der Spannungsvervielfacherschaltung 24 zugeführt wird. Die von letzterer erzeugte Gleichspannung wird den Leitungen 15 und 17 der Versorgungsspannung zugeführt, wobei davon ausgegangen ist, daß die Gleichrichterschaltung 16 gesperrt ist, wenn die Versorgungsspannung auf den Leitungen 15 und 17 größer ist als die von der Gleichrichterschaltung erzeugte Gleichspannung.

Eine Schaltungsanordnung, die mit erhöhter Zuverlässigkeit arbeitet, ist in Fig. 3 dargestellt. Auch hier ist an die Spule 14 über die Leitungen 11 und 13 parallel zur Belastungsanordnung 20 und zur Gleichrichterschaltung 16 eine Spannungserhöherschaltung aus der Schalteranordnung 22 und dem Spannungsvervielfacher 24 angeschlossen. Die von dem Spannungsvervielfacher 24 erzeugte Ausgangsspannung wird hier jedoch über einen Gleichrichter 28 der Leitung 15 für den einen Pol VCC der Versorgungsspannung zugeführt, während die Leitung 17 für den anderen Pol VSS der Versorgungsspannung direkt mit dem Ausgang 27 der Schaltung 24 verbunden ist. Der Ausgang 25 der Schaltung 24 ist direkt mit einer Spannungsvergleicherschaltung 26 verbunden, die auf einer Ausgangsleitung 29 ein Steuersignal erzeugt, wenn die Spannung am Ausgang 25 eine vorgegebene Referenzspannung überschreitet. Die von der Speicherschaltung 18 auf der Leitung 19 abgegebenen Daten steuern in Fig. 3 nur die Schalteranordnung 22, während die Belastungsanordnung 20 nur von dem Steuersignal auf der Leitung 29 gesteuert wird.

Die Funktion der in Fig. 3 dargestellten Schaltungsanordnung ist nun wie folgt. Während der Phase des Datensignals auf der Leitung 19, während der die Belastungsanordnung 20 nicht eingeschaltet sein soll, erzeugt die Gleichrichterschaltung 16 die Versorgungsspannung auf den Leitungen 15 und 17, während die Schalteranordnung 22 die Schaltausgänge 21 und 23 von den entsprechenden Eingängen trennt, so daß die Spannungsvervielfacherschaltung 24 keine Ausgangsspannung und damit die Spannungsvergleicherschaltung 26 kein Ausgangssignal erzeugt.

Wenn nun aufgrund eines Datensignals auf der Leitung 19 die Schalteranordnung 22 eingeschaltet wird und die Schaltausgänge 21 bzw. 23 mit den Eingangsleitungen 11 bzw. 13 verbindet, baut die Spannungsvervielfacherschaltung 24 am Ausgang 25 eine Spannung auf, die schließlich die Referenzspannung im Spannungsvergleicher 26 überschreitet, so daß dieser ein Steuersignal auf der Leitung 29 erzeugt, das die Belastungsanordnung 20 einschaltet.

Damit verringert sich die Wechselspannung auf den Leitungen 11 und 13, so daß die Gleichrichterschaltung 16 keine ausreichende Versorgungsspannung mehr liefern kann, und die Lieferung der Versorgungsspannung wird nun von der Spannungsvervielfacherschaltung 24 über den Gleichrichter 28 übernommen. Es ist klar, daß in dem Spannungsvergleicher 26 die Referenzspannung ausreichend groß gewählt sein muß, damit der Spannungsvergleicher erst anspricht, wenn die Spannungsvervielfacherschaltung 24 eine für die Versorgung der Speicherschaltung 18 ausreichende Versorgungsspannung aufgebaut hat.

Auf diese Weise wird andererseits gleichzeitig die Belastung durch die Belastungsanordnung 20 geregelt, wobei angenommen wird, daß die Höhe der Belastung durch ein analoges Signal auf der Leitung 29 gesteuert werden kann. Wenn nämlich die Belastung so groß ist, daß auch die Spannungsvervielfacherschaltung 24 keine ausreichende Versorgungsspannung am Ausgang 25 erzeugen kann, geht das vom Spannungsvergleicher 26 auf der Leitung 29 erzeugte Signal zurück und verringert die Belastung durch die Belastungsanordnung 20. Mit diesem Regelkreis wird also automatisch die Spannung am Ausgang 25 auf dem im Spannungsvergleicher 26 vorgegebenen Referenzwert und damit auf einem Wert gehalten, der für einen sicheren Betrieb der Speicherschaltung 18 ausreichend ist.

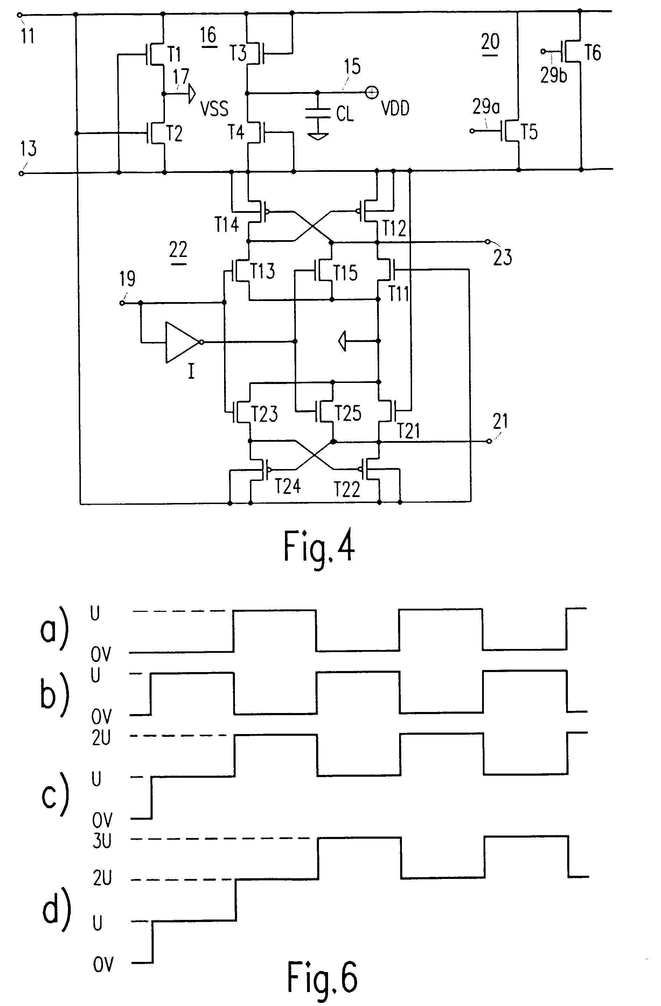

In Fig. 4 ist ein möglicher Aufbau des Gleichrichters 16, der Belastungsanordnung 20 und der Schalteranordnung 22 dargestellt. Diese Anordnungen sind ausschließlich aus Feldeffekttransistoren, abgekürzt mit FET bezeichnet, aufgebaut.

Die Gleichrichterschaltung 16 enthält die FET T1 bis T4, die zwei Zweige bilden. Im ersten Zweig verbinden FETs T1 bzw. T2 die Leitung 11 bzw. 13, die mit der Spule 14 in den Fig. 1 bis 3 verbunden sind, mit dem Anschluß 17 für den einen Pol VSS der zu erzeugenden Gleichspannung. Das Gate jedes der FET T1 und T2 ist mit der jeweils anderen Leitung 13 bzw. 11 verbunden. Wenn die Spannung auf der Leitung 11 positiver ist als auf der Leitung 13, wird der FET T2 leitend und koppelt die Leitung 13 mit dem Anschluß 17. Entsprechendes gilt, wenn die Leitung 13 positiver ist als die Leitung 11. Dabei entsteht praktisch kein Spannungsabfall zwischen dem Anschluß 17 und der jeweils damit gekoppelten Leitung.

Im anderen Zweig sind die FET T3 bzw. T4 zwischen einer der Leitungen 11 bzw. 13 und dem Ausgangsanschluß 15 für den positiven Pol VDD der zu erzeugenden Gleichspannung angeordnet. Die Gates der FET T3 und T4 sind mit der jeweils gleichen Leitung 11 bzw. 13 verbunden. Der Anschluß 15 für die Gleichspannung ist ferner mit einer Kapazität CL verbunden, deren anderer Anschluß mit dem anderen Pol VSS der Gleichspannung verbunden ist, die hier wie auch an anderen Stellen der gesamten Schaltung durch ein Dreieck symbolisiert wird. Durch die Kapazität CL wird eine geglättete Gleichspannung erzeugt. Immer wenn die Spannung auf der Leitung 11 bzw. 13 um die Schwellspannung des FET T3 bzw. T4 positiver wird als die geglättete Gleichspannung, wird der betreffende FET leitend und lädt die Kapazität CL nach. Auf diese Weise erzeugt die Gleichrichterschaltung 16 eine Gleichspannung, die um die Schwellspannung der FET kleiner ist als die maximale Amplitude der Spannung zwischen den Leitungen 11 und 13. Dies ist jedoch nicht weiter nachteilig, da die Gleichrichterschaltung 16 nur bei ausgeschalteter Belastungsanordnung 20 arbeitet, wenn ohnehin eine genügend große Wechselspannung zwischen den Leitungen 11 und 13 vorhanden ist.

Die Schalteranordnung 22 dient dazu, die Ausgänge 21 und 23 mit der Leitung 11 bzw. 13 zu koppeln, wenn sie über ein entsprechendes Datensignal am Eingang 19 eingeschaltet ist, oder im ausgeschalteten Zustand die Ausgänge fest mit dem negativen Pol der Gleichspannung zu verbinden.

Die FET T11 und T21 sind zwischen die Ausgänge 23 bzw. 21 und den negativen Pol der Gleichspannung geschaltet, und die Gates sind ebenso wie bei den FET T1 und T2 mit der jeweils anderen Leitung 11 bzw. 13 verbunden. Über diesen Anschluß und den entsprechenden FET T1 bzw. T2 der Gleichrichterschaltung 16 ist der Ausgangsanschluß 21 bzw. 23 mit der betreffenden Leitung 11 bzw. 13 gekoppelt, wenn die Spannung auf dieser Leitung niedriger ist gegenüber der jeweils anderen Leitung. Dies gilt unabhängig von dem Signal am Eingang 19.

Um einen der Ausgänge 21 bzw. 23 mit einer positive Spannung führenden Leitung 11 bzw. 13 zu verbinden, dienen die FET T12 bzw. T22. Wenn der Eingang 19 eine positive Spannung erhält, sind die FET T13 und T23 leitend, so daß damit die P-Kanal-FET T12 und T22 ebenfalls leitend sind, sobald die Spannung auf der betreffenden Leitung 11 bzw. 13 um mehr als die Schwellspannung positiv gegenüber dem negativen Pol der Gleichspannung sind, wobei die betreffenden Ausgänge 21 bzw. 23 dann ohne Spannungsabfall mit der zugehörigen Leitung 11 bzw. 13 gekoppelt sind. Dadurch kann der an die Ausgänge 21 und 23 angeschlossene Spannungsvervielfacher mit der maximal verfügbaren Spannung arbeiten.

Bei einem hohen Signal am Eingang 19 sind andererseits die FET 15 und 25 über den Inverter I gesperrt, und durch die leitenden FET T12 und T22 sind die P-Kanal-FET T14 und T24 ebenfalls gesperrt.

Bei einem niedrigen Signal am Eingang 19 werden die FET T13 und T23 gesperrt und über den Inverter I die FET T15 und T25 leitend, und damit werden die Ausgänge 21 und 23 ständig mit dem negativen Pol der Gleichspannung gekoppelt, und ferner werden die FET T14 und T24 leitend, wodurch die FET T12 und T22 dauernd gesperrt sind. Dieser Zustand der Schalteranordnung 22 wird als abgeschaltet bezeichnet.

Die Belastungsanordnung 20 besteht aus den beiden FET T5 und T6, die parallel mit den Leitungen 11 und 13 verbunden sind. Die Gates dieser FET sind mit Eingängen 29a und 29b verbunden, die von Spannungsvergleichern angesteuert werden, die später erläutert werden.

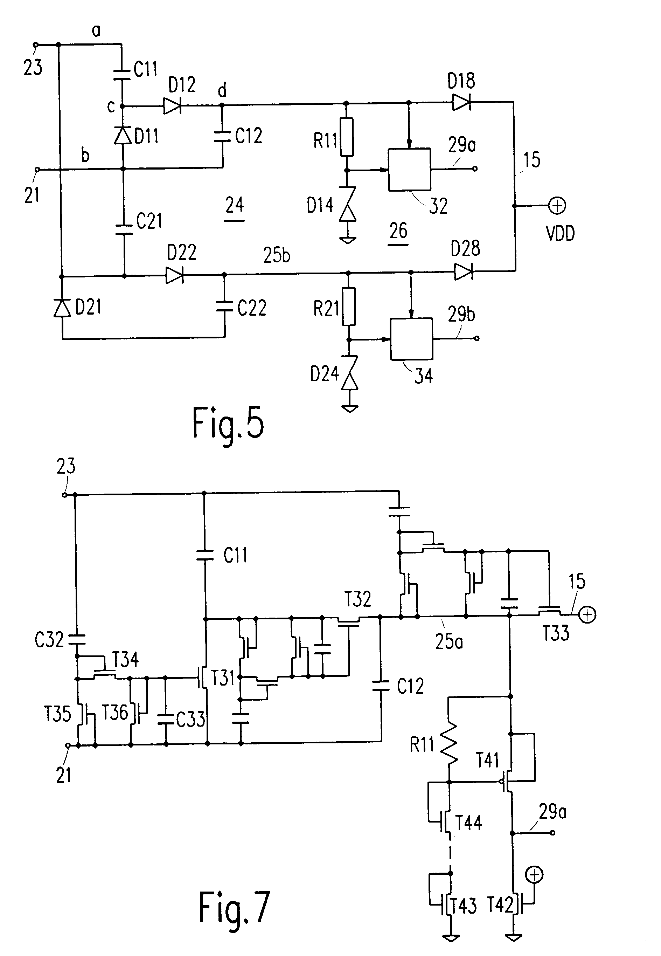

Ein Aufbau für den Spannungsvervielfacher 24 in Fig. 3 ist in Fig. 5 näher dargestellt, wobei gleichzeitig auch der Spannungsvergleicher 26 näher angegeben ist. Der Spannungsvervielfacher 24 besteht aus zwei Teilen, die -untereinander gleich aufgebaut sind, jedoch umgekehrt zueinander mit den Schalteingängen 21 und 22 verbunden sind, so daß die beiden Teile um eine halbe Phase der impulsförmigen periodischen Eingangsspannungen an den Schalteingängen 21 und 23 versetzt arbeiten. Zur Vereinfachung wird daher nachfolgend die Funktion nur des einen Teils des Spannungsvervielfachers 24 anhand der Fig. 6 erläutert, die den zeitlichen Verlauf der Spannungen an den vier Punkten a, b, c und d in der Schaltung nach Fig. 5 zeigen. Dabei ist zur weiteren Vereinfachung angenommen, daß die Spannungen der Punkte a und b, d.h. Schalteingänge 21 und 23, rechteckförmig zwischen OV und U gegenphasig schwanken.

Wenn in der ersten betrachteten Phase der Punkt b auf der Spannung U liegt, wird die Kapazität C11 über die Diode D11 aufgeladen, d.h. der Punkt c geht auf U, und über die Diode D12 geht der Punkt d ebenfalls auf U. Wenn in der nächsten Phase der Punkt a die Spannung U hat, geht der Punkt c auf 2U, und damit wird über die Diode D12 die Kapazität C12 am Punkt d ebenfalls auf 2U aufgeladen, wobei Spannungsabfälle an den Dioden D11 und D12 sowie Spannungsverluste an den Kapazitäten durch Umladung vereinfacht nicht berücksichtigt werden.

Mit der nächsten Phase hat der Punkt b wieder die Spannung U und der Punkt a OV, so daß der Punkt c wieder auf U nachgeladen wird, der Punkt d jetzt jedoch auf 3U geht. Mit der nächsten Phase, in der der Punkt b wieder OV hat, geht der Punkt d wieder auf 2U und wird wieder von der Kapazität C11 über die Diode D12 nachgeladen. Auf diese Weise schwankt die Spannung auf der Leitung 25a periodisch zwischen 2U und 3U. Dies ist auf der Leitung 25b ebenfalls der Fall, jedoch um eine Phase verschoben, so daß über die Dioden D18 und D28 auf der Leitung 15 für die positive Versorgungsspannung VDD ständig die Spannung 3U vorhanden ist, insbesondere wenn die an die Leitung 15 in Fig. 4 angeschlossene Ladekapazität CL berücksichtigt wird. Die Dioden D18 und D28 entsprechen dem Gleichrichter 28 in Fig. 3.

Wegen der periodisch schwankenden Spannung auf den Leitungen 25a und 25b besteht der Spannungsvergleicher 26 hier ebenfalls aus zwei Teilen R11, D14 und dem Block 32 sowie aus R21, D24 und dem Block 34, die untereinander gleich aufgebaut sind. Über den Widerstand R11 und die Zener-Diode D14 wird eine Referenzspannung erzeugt, und der Block 32 gibt am Ausgang 29a ein Signal ab, wenn die Spannung auf der Leitung 25a eine vorgegebene Beziehung zur Referenzspannung hat, beispielsweise um einen vorgegebenen Faktor oder ein vorgegebenes absolutes Maß höher ist. Damit wird am Ausgang 29a ein periodisches Signal erzeugt. Das gleiche gilt für den Ausgang 29b des Blocks 34, wo dieses Signal jedoch gegenüber dem Signal am Ausgang 29a um eine Phase verschoben ist.

Die Ausgänge 29a und 29b in Fig. 5 sind mit den Gates der FET T5 und T6 in Fig. 4 verbunden, so daß stets einer von diesen beiden leitend ist, wenn die Schalteranordnung 22 eingeschaltet ist und der Spannungsvervielfacher 24 eine höhere Spannung erzeugt. Über die Steuerung der Belastungsanordnung aus den FET T5 und T6 über den Spannungsvergleicher 26 wird die Spannung zwischen den Leitungen 11 und 13 auf einen Wert geregelt, der stets gleich einem Drittel der Spannung ist, bei der der Spannungsvergleicher 26 anspricht, so daß die Gleichspannung VDD auf der Leitung 15 zur Versorgung der übrigen, nicht dargestellten Schaltungen stets einen vorgegebenen Mindestwert aufweist.

Der Spannungsverlust an den Kapazitäten C11, C12, C21 und C22, der im praktischen Fall tatsächlich durch Umladung auftritt, kann im eingeschwungenen Zustand gering gehalten werden, wenn die Werte der Kapazitäten unter Berücksichtigung der Frequenz der Eingangsspannung und der Belastung durch die übrige Schaltung ausreichend groß ist. Der Spannungsabfall an den Dioden D11, D12 und D18 sowie D21, D22 und D28 kann dagegen gering gehalten werden, wenn diese Dioden in einer Form realisiert werden, die in Fig. 7 näher dargestellt ist. Diese zeigt lediglich den einen Teil des Spannungsvervielfachers 24 und des Spannungsvergleichers 26, da der andere Teil gleich aufgebaut ist. Die Diode D11 in Fig. 5 wird im wesentlichen durch einen FET T31 gebildet, dessen Gate mit einer Vorspannungsschaltung verbunden ist, die dem Gate eine Vorspannung etwa in der Größe der Schwellspannung des FET T31 zuführt, so daß dieser bereits leitend ist, wenn die Spannung am Schalteingang 21 nur geringfügig höher ist als die Spannung am Kondensator C11.

Die Vorspannungsschaltung umfaßt eine Kapazität C33, die die Vorspannung am Gate des FET T31 weitgehend konstant gegenüber dem mit dem Eingang 21 verbundenen Anschluß hält und die über den FET T34 periodisch auf folgende Weise nachgeladen wird. Wenn die Spannung am Eingang 21 positiv gegenüber der Spannung am Eingang 23 ist, wird die Kapazität C32 über den FET T35 aufgeladen. Wenn anschließend in der nächsten Phase die Spannung am Eingang 23 positiv gegenüber der Spannung am Eingang 21 ist, wird Ladung von der Kapazität C32 über den FET T34 auf die Kapazität C33 übertragen. Wenn dadurch die Spannung an der Kapazität C33 die Schwellspannung des FET T36, die gleich der Schwellspannung des FET T31 ist, überschreitet, wird dieser FET T31 leitend und begrenzt damit die Spannung über der Kapazität C33 und damit am Gate des FET T31 auf die Schwellspannung. Auf diese Weise wird eine Diode D11 in Fig. 5 realisiert, die nahezu keinen Spannungsabfall aufweist. In entsprechender Weise ist die Diode D12 durch einen FET T32 realisiert, der mit einer Vorspannungsschaltung verbunden ist, die auf gleiche Weise aufgebaut ist und arbeitet wie die Vorspannungsschaltung des FET T31. Auf der Leitung 25a entsteht somit eine Spannung, die, abgesehen von geringen Ladungsverlusten der Kapazitäten C11 und C12, maximal weitgehend gleich der dreifachen Amplitude der Spannung zwischen den Eingängen 21 und 23 ist. Diese Spannung wird über den FET T33, der ebenfalls eine Vorspannungsschaltung mit dem beschriebenen Aufbau aufweist, der Leitung 15 für die positive Versorgungsspannung zugeführt, die somit ebenfalls weitgehend gleich dem Dreifachen der Schaltspannung zwischen den Eingängen 21 und 23 ist.

Die Spannung auf der Leitung 25 wird ferner über den Widerstand Rll einer Kette von FET T43 ... T44 zugeführt, die der Zener-Diode D14 mit einer Zener-Spannung gleich der Kette von Schwellspannungen der FET T43 bis T44 entspricht. Der Verbindungspunkt des Widerstands R11 mit der Kette von FET ist mit dem Gate eines P-Kanal-FET T41 verbunden, dessen einer Hauptanschluß ebenfalls mit der Leitung 25a verbunden ist. Wenn die Spannung auf der Leitung 25a so hoch ist, daß über den Widerstand R11 infolge des Stroms durch die FETs T43 bis T44 eine Spannung gleich der Schwellspannung des FET T41 abfällt, wird dieser leitend und bringt den Ausgang 29a damit auf eine positive Spannung, so daß der daran angeschlossene FET T5 der Belastungsanordnung 20 in Fig. 4 leitend wird. Der FET T42, dessen Gate mit der Versorgungsspannung verbunden ist, dient dabei lediglich als Arbeitswiderstand.

## Patentansprüche

1. Schaltungsanordnung mit einer Speicherschaltung zum Erzeugen einer Versorgungsspannung für die Speicherschaltung, die gespeicherte Daten nach außerhalb abgibt, mit einer Spule zum Empfangen eines magnetischen Wechselfeldes und Erzeugen einer Wechselspannung und einer an die Spule angeschlossenen Gleichrichterschaltung zum Erzeugen der Versorgungsspannung aus der Wechselspannung, einer an die spule augechlossenen Belastungsanordnung zum Erzeugen einer von den abzugebenden Daten abhängigen erhöhten Belastung der Spule,
dadurch gekennzeichnet, daß parallel zur Gleichrichterschaltung (16) eine von den abzugebenden Daten gesteuerte Spannungserhöherschaltung (22, 24) an die Spule (14) angeschlossen ist zum Erzeugen einer gegenüber der Amplitude der Wechselspannung höheren Gleichspannung an einen Spannungsausgang als Versorgungsspannung für die Speicherschaltung (18) während der Dauer der erhöhten Belastung.

2. Schaltungsanordnung nach Anspruch 1,
dadurch gekennzeichnet, daß der Spannungsausgang (25) der Spannungserhöherschaltung (22, 24) über eine gleichrichtende Anordnung (28) mit einem Versorgungsspannungseingang (15) der Speicherschaltung (18) und direkt mit einer Spannungsvergleicherschaltung (26) verbunden ist, die ein Steuersignal abgibt, wenn die höhere Gleichspannung einen vorgegebenen Wert erreicht, und daß die Belastungsanordnung (20) nur von diesem Steuersignal gesteuert die Belastung der Spule (14) erhöht.

3. Schaltungsanordnung nach Anspruch 1 oder 2,
dadurch gekennzeichnet, daß die Spannungserhöherschaltung (22, 24) eine Schalteranordnung (22) mit einem Steuereingang zum Empfangen der abzugebenden Daten, zwei Eingängen, die mit der Spule verbunden sind, und zwei Schaltausgängen, die abhängig von den am Steuereingang empfangenen Daten mit einem zugeordneten Eingang bzw. mit einem Pol der Versorgungsspannung gekoppelt sind, und eine Spannungsvervielfacherschaltung (24) umfaßt, die mit den Schaltausgängen (21, 23) verbunden ist.

4. Schaltungsanordnung nach Anspruch 3 mit wenigstens einer Spannungsvervielfacherschaltung, die mit Kapazitäten und gleichrichtenden Anordnungen aufgebaut ist,
dadurch gekennzeichnet, daß jede gleichrichtende Anordnung (D11, D12, D18, D21, D22, D28) durch die Hauptstrombahn eines ersten Feldeffekttransistors (T31 bis T33) gebildet ist, dessen Gate mit einer Vorspannungsschaltung verbunden ist zum Liefern einer Vorspannung für das Gate gegenüber einem Anschluß der Hauptstrombahn, um die wirksame Schwellenspannung des Feldeffekttransistors im leitenden Zustand zu verringern, wobei die Vorspannungsschaltung Kapazitäten (C31, C32) und gleichrichtende Anordnungen in Form von weiteren Feldeffekttransistoren (T34 bis T36) enthält.

## Claims

1. A circuit arrangement comprising a storage circuit for generating a supply voltage for the storage circuit which outputs stored data to the environment, a coil for receiving a magnetic alternating field and for generating an alternating voltage, a rectifier circuit which is connected to the coil in order to generate the supply voltage from the alternating voltage, and a load device which is connected to the coil in order to generate an increased load of the coil which is dependent on the data to be output, characterized in that parallel to the rectifier circuit (16) a voltage boost circuit (22, 24) which is controlled by the data to be output is connected to the coil (14) in order to generate a direct voltage which is higher relative to the amplitude of the alternating voltage on a voltage output and serves as a supply voltage for the storage circuit (18) for the duration of the increased load.

2. A circuit arrangement as claimed in Claim 1, characterized in that the voltage output (25) of the voltage boost circuit (22, 24) is connected to a supply voltage input (15) of the storage circuit (18) *via* a rectifier device (28) and directly to a voltage comparator circuit (26) which outputs a control signal when the higher direct voltage reaches a predetermined value, the load device (20) increasing the load of the coil (14) only under the control of said control signal.

3. A circuit arrangement as claimed in Claim 1 or 2, characterized in that the voltage boost circuit (22, 24) comprises a switching device (22) which includes a control input for receiving the data to be output, two inputs which are connected to the coil, and two switching outputs which are coupled to an associated input or to one pole of the supply voltage, in dependence on the data received on the control input and also comprises a voltage multiplier circuit (24) which is connected to the switching outputs (21, 23).

4. A circuit arrangement as claimed in Claim 3, comprising at least one voltage multiplier circuit consisting of capacitances and rectifier devices, characterized in that each rectifier device (D11, D12, D18, D21, D22, D28) is formed by the main current path of a first field effect transistor (T31 to T33) whose gate is connected to a bias circuit in order to supply a bias voltage for the gate relative to a terminal of the main current path, thus reducing the effective threshold voltage of the field effect transistor in the turn-on state, the bias circuit comprising capacitances (C31, C32) and rectifier devices in the form of further field effect transistors (T34 to T36).

## Revendications

1. Montage de circuit pourvu d'un circuit de mémoire pour générer une tension d'alimentation pour le circuit de mémoire, qui délivre des données mémorisées vers l'extérieur, comportant une bobine pour recevoir un champ magnétique alternatif et produire une tension alternative, un circuit redresseur connecté à la bobine pour générer la tension d'alimentation à partir de la tension alternative et un dispositif de charge, connecté à la bobine, pour générer une augmentation de charge de la bobine en fonction des données à délivrer, caractérisé en ce qu'un circuit élévateur de tension (22, 24) commandé par les données à délivrer est connecté à la bobine (14) en parallèle avec le circuit redresseur (16) afin de générer, comme tension d'alimentation pour le circuit de mémoire (18), une tension continue plus élevée par rapport à l'amplitude de la tension alternative sur une sortie de tension au cours de la durée d'augmentation de la charge.

2. Montage de circuit selon la revendication 1, caractérisé en ce que la sortie de tension (25) du dispositif élévateur de tension (22, 24) est connectée, via un dispositif redresseur (28), à une entrée de tension d'alimentation (15) du circuit de mémoire (18) et directement à un circuit de comparaison de tension (26), qui délivre un signal de commande lorsque la tension continue plus élevée atteint une valeur prédéterminée, et en ce que le dispositif de charge (20) n'augmente la charge de la bobine (14) que sous la commande de ce signal de commande.

3. Montage de circuit selon la revendication 1 ou 2, caractérisé en ce que le circuit élévateur de tension (22, 24) comporte un dispositif de commutation (22) avec une entrée de commande pour recevoir les données à délivrer, deux entrées, qui sont connectées à la bobine, et deux sorties de commutation, qui sont couplées, en fonction des données reçues à l'entrée de commande, à une entrée associée ou à un pôle de la tension d'alimentation, et un circuit multiplicateur de tension (24) qui est connecté aux sorties de commutation (21, 23).

4. Montage de circuit selon la revendication 3 avec au moins un circuit multiplicateur de tension qui est conçu avec des capacités et des dispositifs redresseurs, caractérisé en ce que chaque dispositif redresseur (D11, D12, D18, D21, D22, D28) est formé par le trajet de courant principal d'un premier transistor à effet de champ (T31 à T33), dont la grille est connectée à un circuit de polarisation pour délivrer une tension de polarisation pour la grille vis-à-vis d'une borne du trajet de courant principal, afin de réduire la tension de seuil effective du transistor à effet de champ à l'état conducteur, le circuit de polarisation comprenant des capacités (C31, C32) et des dispositifs redresseurs sous la forme d'autres transistors à effet de champ (T34 à T36).
